(19) Europäisches Patentamt

European Patent Office

Office européen des brevets

(11) **EP 0 862 062 B1**

(12) **EUROPEAN PATENT SPECIFICATION**

(45) Date of publication and mention
of the grant of the patent:
**13.11.2002   Bulletin 2002/46**

(51) Int Cl.⁷: $G01R\ 31/312$, G01R 31/28

(21) Application number: **98103455.6**

(22) Date of filing: **27.02.1998**

(54) **Circuit board inspection apparatus and method**

Verfahren und Vorrichtung zum Prüfen von Leiterplatten

Procédé et dispositif de contrôle de cartes de circuit

(84) Designated Contracting States:
**DE FR GB**

(30) Priority: **28.02.1997   JP 4611497**

(43) Date of publication of application:
**02.09.1998   Bulletin 1998/36**

(73) Proprietor: **Nidec-Read Corporation**
**Uji-city, Kyoto 611-0041 (JP)**

(72) Inventor: **Takahashi, Tadashi**
**Uji-City, Kyoto 611-0041 (JP)**

(74) Representative:
**von Fischern, Bernhard, Dipl.-Ing. et al**
**Hoffmann - Eitle,**
**Patent- und Rechtsanwälte,**
**Arabellastrasse 4**
**81925 München (DE)**

(56) References cited:
**EP-A- 0 633 478          EP-A- 0 636 887**
**GB-A- 2 143 954          JP-A- 8 054 448**
**US-A- 5 498 964**

**Description**

The present invention relates to a circuit board inspection apparatus and method for the inspection of the continuity of wiring formed on a circuit board.

A method of contacting probes with both ends of a printed pattern is one of the methods for inspecting the continuity of a printed pattern formed on a printed circuit board. The continuity of the printed pattern can be inspected by checking whether a predetermined current flows when a voltage is applied between both probes.

This method, however, is difficult to apply to a pad section with a fine pitch in which the ends of adjacent printed patterns are located very close to each other. That is, probes compatible with fine pitches are generally expensive and a technique for aligning probes with a substrate very accurately must be used during inspections. In addition, since the probes are contacted with pads, the pads may be damaged.

One of the inspection methods that attempt to solve this problem uses anisotropic conducting rubber instead of the probes (Japanese Patent Application Laid Open No. 61-62877). This method enables the continuity of a printed pattern with a fine-pitch pad section to be inspected without using expensive probes compatible with fine pitches or damaging the pads.

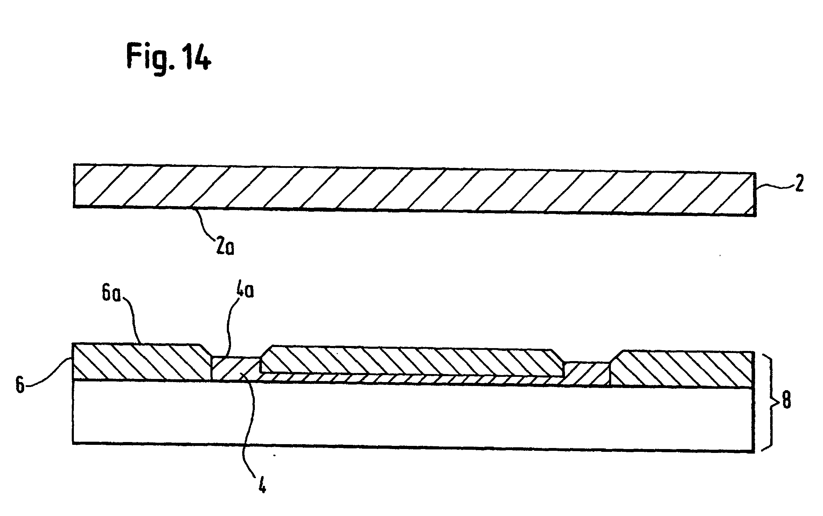

With a method of using anisotropic conducting rubber 2, however, pressing the rubber 2 against a circuit board 8 may not allow the bottom surface 2a of the rubber 2 to abut the top surface 4a of a pad 4 if there is a resist 6 having a top surface 6a above the top surface 4a of the pad 4, as shown in Figure 14. This configuration causes poor contact during an inspection.

One of the methods that attempted to solve this problem uses a non-contact sensor (Japanese Patent Application Laid Open No. 4-244976 and Japanese Patent Application Laid Open No. 58-38874). This method enables a signal to be transmitted between the pads and the sensor despite the resists around the pads.

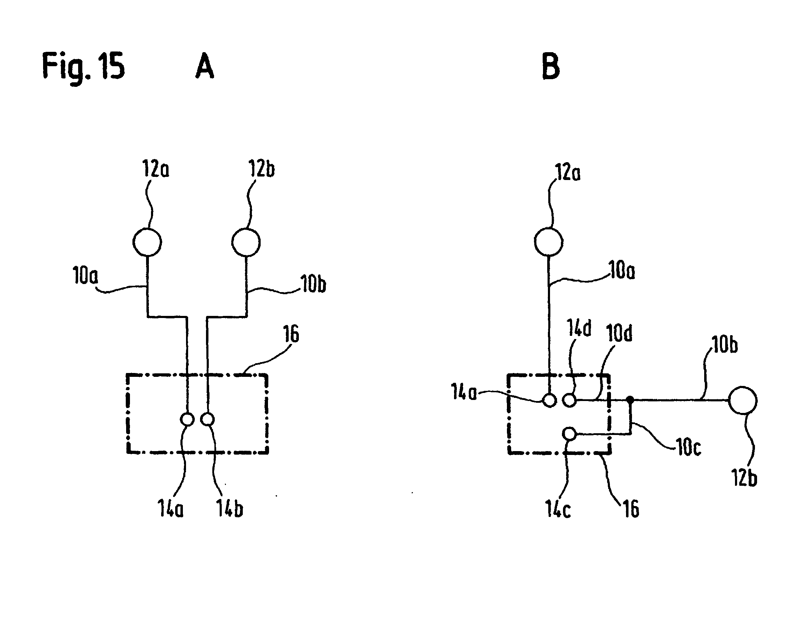

For example, the method described in Japanese Patent Application laid open No. 4-244976 connects to probes (not shown) one ends 12a, 12b of a plurality of printed patterns 10a, 10b to be inspected and collectively couples the other ends 14a, 14b to a non-contact sensor 16 as shown in Figure 15.

If, however, the printed patterns are complicated or irregular, e.g., if they branch on the side of the non-contact sensor 16 as shown in Figure 15B and if one of the branching printed patterns 10c or 10d is open-circuited, an inspection current flows between the probe connected to the end 12b and the non-contact sensor 16 when the other printed pattern 10c or 10d and the printed pattern 10b are not open-circuited. Consequently, the open circuit of the branching portion cannot be detected accurately.

On the other hand, the method described in Japanese Patent Application laid open No. 58-38814 is difficult to apply if the printed patterns are disposed with a high density on the non-contact sensor side due to its structure. In addition, if any printed pattern branches on the side opposite to the non-contact sensor, then the open circuit in the branching portion cannot be detected accurately, as described above. That is, none of the non-contact sensors is very reliable in inspections.

EP-A-0 636 887 describes a probe for capacitive open-circuit tests. In a capacitive-probe assembly used in an automatic circuit tester to sense varying electric fields that result adjacent to integrated-circuit packages during tests of circuit board, a spacer comprising resilient cellular material has a double-sided-board attached to it that provides the probe plate to which the device signals are capacitively coupled. The spacer is in turn mounted on a chip-probe mounting surface provided by the tester's fixture.

GB-A-2143954 describes a capacitive method and apparatus for checking connections of a printed circuit board.

JP-8-54448 shows a feed control element used in substrate inspection for inspecting a circuit pattern. The feed control element has a laminated structure and a voltage is applied by irradiating with a laser beam. An electrostatic capacitance coupling under a non-contact system is provided on the detection side.

US-5,498,964 describes a capacitive electrode system for detecting open solder joints in printed circuit assemblies.

EP-A-0 633 478 shows a method and device for testing electronic circuit boards, in which an electric pulse signal is supplied to a pin of a integrated circuit on an electric circuit board, and by means of an electrode facing the casing of the integrated circuit, the electric field produced inside the casing by the pulse signal is detected.

It is an object of this invention to provide an inexpensive and reliable circuit board inspection apparatus and method that can be applied to a circuit board that is wired with a high density, and to solve the above-mentioned problems caused by branching printed patterns.

This object is achieved by a device having the features of claim 1, and a method having the steps described in claim 16. Advantageous embodiments are contained in the dependent claims.

According to this invention, the term "circuit board" refers to a substrate on which wiring can be or has been formed and is not limited in terms of its material, structure, shape, or sizes. The circuit board includes, for example, a glass epoxy circuit board, a film-like circuit board, and a package on which circuit elements such as EL CPU are mounted. It also includes a composite circuit board comprising sockets on a glass epoxy circuit board and a circuit board on which circuit elements are mounted.

The term "wiring" refers to a conductor that is used to conduct electricity and is not limited in terms of its material, structure, shape, or sizes. This includes printed patterns, through-holes, and pins that are formed on the circuit board as well as the conducting section of electric cords, sockets, connectors, and pins attached to the circuit board.

The term "one end of the wiring" or "the other end of the wiring" refers to a point of the wiring to or from which an inspection signal is input or output and that is not limited in terms of its material, structure, shape, or size. This includes an electric connection point to which a different component is connected such as an inspection-end or a connector-connection-end of the printed pattern, a connection pin, a pad to which a bonding wire is connected, a pad to which a circuit element or a socket is connected, an insertion portion formed in a socket mounted on the circuit board, and an I/O end of a connector, as well as an arbitrary point within the wiring.

The term "coupling" refers to coupling two or more members together so that a signal can be transmitted among the members while they are insulated from one another. This includes coupling by means of electrostatic capacity or inductance.

The term "signal refers to a signal used for inspections and is a concept including either a voltage or a current. It includes an alternating signal such as sine waves, a direct signal, rectangular and triangular signals, and a pulse signal.

The expression "based on a voltage generated between the first and the second terminals" means that something is based on a voltage generated between the first and the second terminals or a physical quantity corresponding to or associated with the voltage. Thus, this physical quantity includes not only the voltage but also a current corresponding to or associated with the voltage, and its integrated and differential values.

The term "detection of the continuity of the wiring" includes the detection of an open circuit or shorting in the wiring and the detection of the resistance value of the wiring such as a semi-open-circuit.

The term "group" refers to a set of one or two or more elements.

The term "signal with rapid changes" refers to a signal such as a voltage or a current that is subjected to frequent changes per unit time, and it includes, for example, a direct signal having a step-like rising or falling edge, triangular and a rectangular signals, and a pulse signal.

The term "electrode section" refers to a conductor constituting an electrode on the second electrode side when electrostatic capacity is used for coupling and is not limited in terms of its material, structure, shape or sizes.

## Brief Description of the Drawings

Figure 1 shows the configuration of a bare-board tester that is a circuit-board inspection apparatus according to one embodiment of this invention.

Figure 2 shows the detailed view of a printed pattern section 34 on an inspected circuit board 32.

Figure 3A is a plan view of a sensor module 50. Figure 3B is a perspective view of the bottom surface of the sensor module 50 as seen from above.

Figure 4A is a plan view schematically showing a sensor unit 52. Figure 4B is a cross-sectional view schematically showing the integral part of the sensor unit 52. Figure 4C is a bottom view schematically showing the sensor unit 52.

Figure 5A is a plan view schematically showing a sensor unit 52 according to another embodiment. Figure 5B is a cross-sectional view schematically showing the integral part of this sensor unit 52. Figure 5C is a bottom view schematically showing this sensor unit 52.

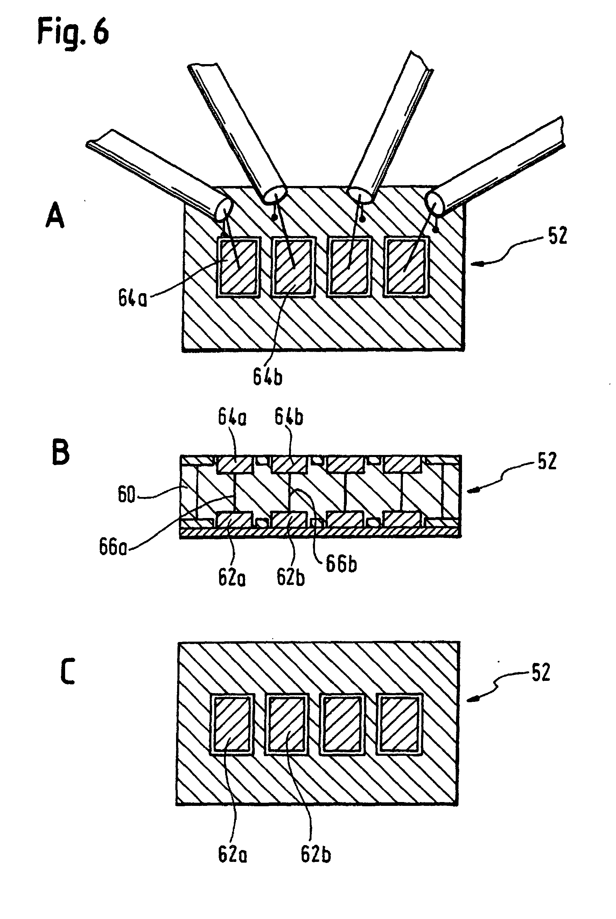

Figure 6A is a plan view schematically showing a sensor unit 52 according to yet another embodiment. Figure 6B is a cross-sectional view schematically showing the integral part of this sensor unit 52; Figure 6C is a bottom view schematically showing this sensor unit 52.

Figure 7A schematically shows the switch section SW1. Figure 7B schematically shows the switch section SW2.

Figure 8 illustrates signal processing.

Figure 9 is a timing chart showing signal processing.

Figure 10 is a timing chart showing another example of signal processing.

Figure 11A shows a signal output from a signal source 46 in the example in Figure 10.

Figure 11B shows a signal output from the signal source 46 in yet another example.

Figure 12 illustrates signal processing according to another embodiment.

Figure 13 is a timing chart showing signal processing according to the embodiment in Figure 12.

Figure 14 illustrates an example of a conventional inspection of the continuity of printed patterns.

Figure 15A illustrates another example of a conventional inspection of the continuity of printed patterns. Figure 15B illustrates yet another example of a conventional inspection of the continuity of printed patterns.

## Detailed description of the preferred embodiment

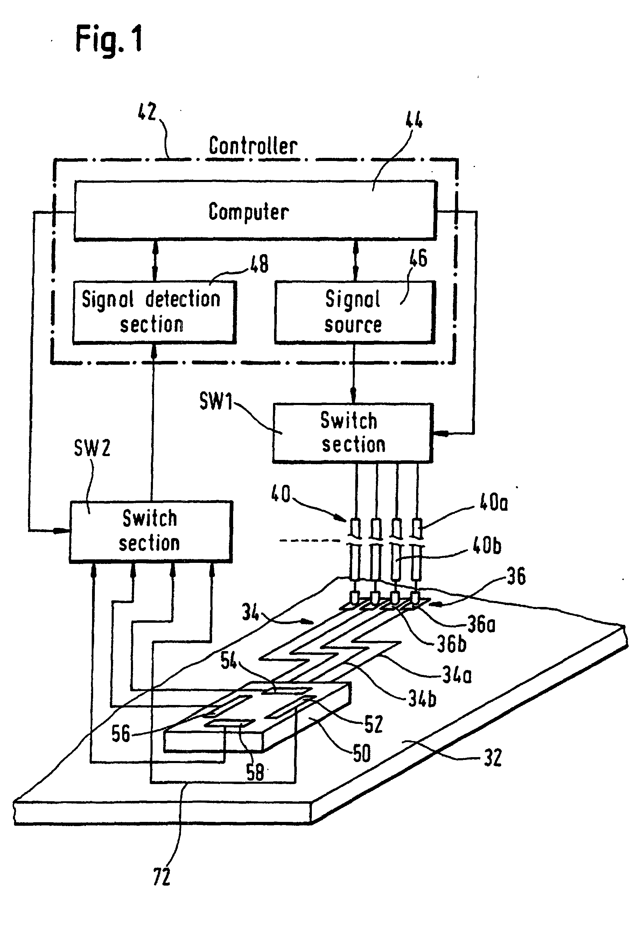

Figure 1 shows a bare board tester that is a circuit board inspection apparatus according to one embodiment of the present invention. This bare board tester inspects the continuity of printed patterns on a printed circuit board (a bare board) before circuit elements are mounted on the board.

An example of an inspected circuit board is described. A plurality of printed patterns 34a, 34b, ... are formed on a circuit board 32 and collectively called a printed pattern section 34. Pads 36a, 36b, ... are formed at one end of the printed patterns 34a, 34b, ... and collectively called a pad section 36.

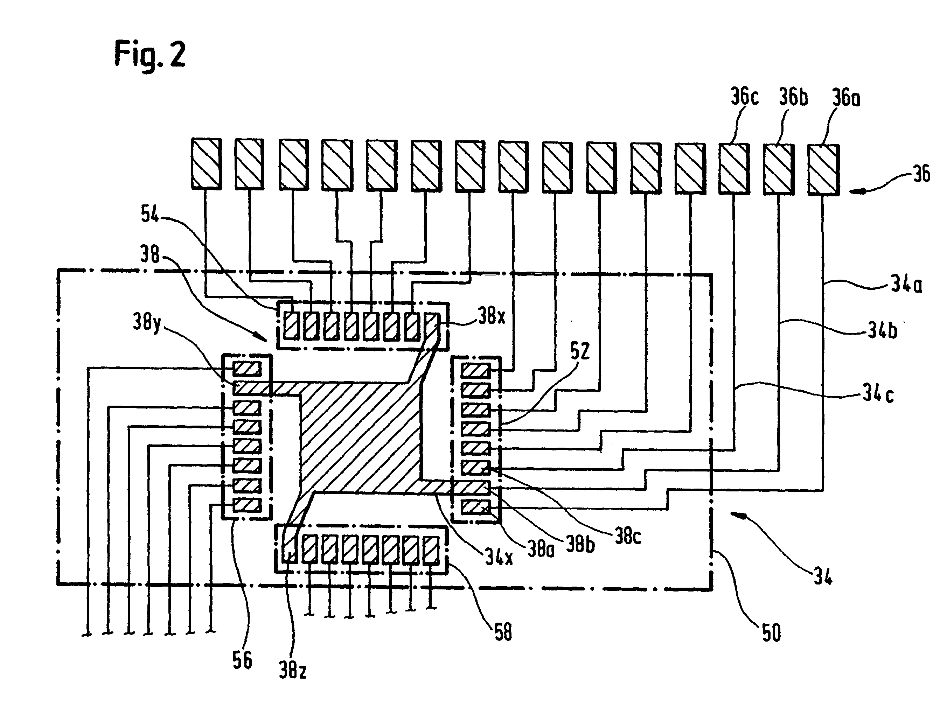

Figure 2 shows the printed pattern section 34 in detail. Pads 38a, 38b, ... are formed at the other ends of the printed patterns 34a, 34b, ... and collectively called a pad section 38. The pad section 38 shown in Figure 2 is called a QFP pattern on which QFPs (quad flat packages that are thin and roughly square) are mounted. Thus, the pitch at which the pads 38a, 38b, ... are arranged is very small. In addition, in this QFP pattern, the pad 38b and the pads 38x, 38y and 38z are connected by the printed pattern 34x to form a ground line.

Referencing back to Figure 1, the bare board tester includes probes 40a, 40b, ... that are a plurality of first terminals connected to the pads 36a, 36b, ... on the circuit board 32. The plurality of probes 40a, 40b, ... is collectively called a probe section 40.

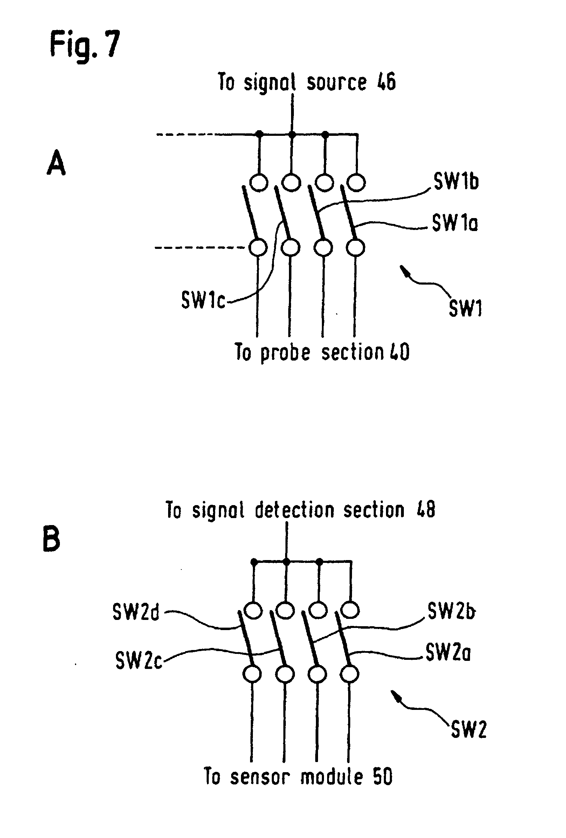

An inspection signal generated by a signal source 46 is delivered to a switch section SW1 that is a first switch means. Figure 7A schematically shows the switch SW1. The switch section SW1 includes a plurality of switches SW1a, SW1b, ... Each switch is turned on and off in response to an instruction from a computer 44 to transmit a signal provided by the signal source 46 to a desired probe in the prove section 40, for example, the probe 40a, as shown in Figure 1 (in this case, only the switch SW1a is turned on).

The signal transmitted to the probe 40a is provided to the pad 38a (see Figure 2) of the pad section 38 via the pad 36a of the pad section 36 connected to the probe 40a and the printed pattern 34a in the printed pattern section 34.

A sensor module 50 is located on the pad section 38 on the circuit board 32. The sensor module 50 is coupled to the pad section 38 to obtain a signal from the pad section 38 and to supply it to a switch section SW2 that is a second switch means.

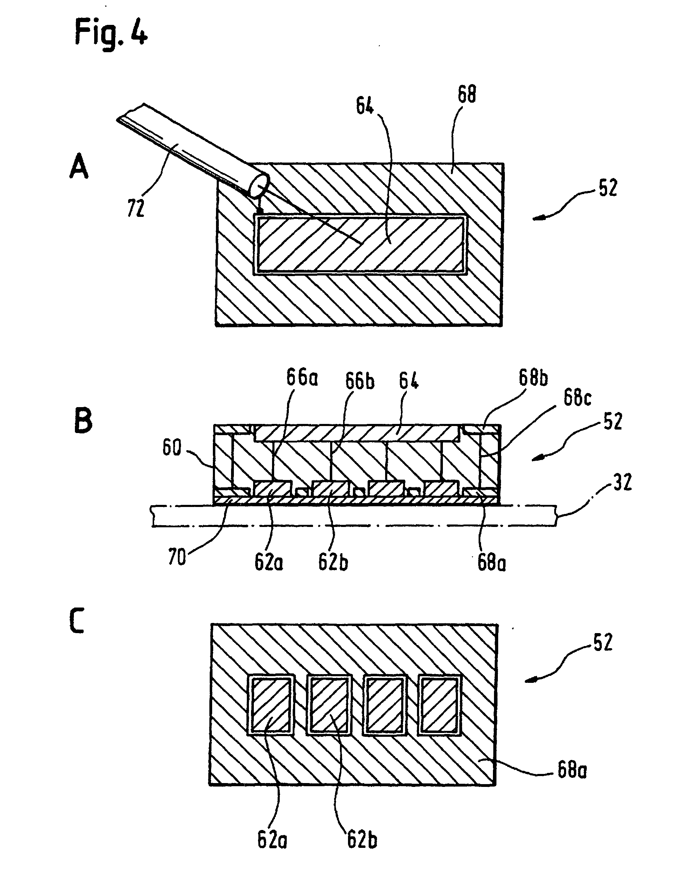

The sensor module 50 comprises a four sensor units 52, 54, 56 and 58 integrally formed. Each sensor unit corresponds to a second terminal. According to this embodiment, the sensor module 50 is composed of a circuit board 60 (see Fig. 4B) that is manufactured through a process similar to the inspected circuit board 32.

Figures 4A, 4B and 4C schematically shows the sensor unit 52 constituting part of the sensor module 50. In the example in Figure 2, the sensor unit 52 corresponds to the eight pads 38a, 38b, ... (these eight pads form one group) but is shown to correspond to four pads in Figures 4A, 4B and 4C for the convenience of explanation.

Figure 4A is a plan view of the sensor unit 52. Figure 4B is a cross sectional view showing an integral part. Figure 4C is a bottom view. As shown in Figures 4B and 4C, electrode plates 62a, 62b, ... constituting an electrode section are independently provided on the bottom surface of the circuit board 60. An insulating film 70 is formed to cover the electrode plates 62a, 62b, ...

The electrode plates 62a, 62b, ... are located opposite to the pads 38a, 38b, ... (see Figure 2) of the pad section 38 of the inspected circuit board 32 which are located to correspond to the sensor unit 52 so as to form a group. The electrode plate is designed with nearly the same shape as each pad. Thus, for example, the electrode 62a and insulating film 70 of the sensor unit 52 and the pad 38a of the inspected circuit board 32 form a capacitor. This is true of the other electrode plates 62b, ...

As shown in Figures 4B and 4A, a connection plate 64 that is a connection conducting section is provided on the top surface of the circuit board 60. The connection plate 64 is electrically connected to the electrode plates 62a, 62b, ... via through-holes 66a, 66b, ... Thus the connection plate 64 of the sensor unit 52 is capacitively coupled to the group of pads 38a, 38b, ... described above. As shown in Figure 4A, the connection plate 64 is connected to the switch section SW2 via a connection cord 72. The connection plate 64 and the through-holes 66a, 66b, ... correspond to connection means.

In addition, as shown in Figures 4A, 4B and 4C, shield films 68a and 68b that are shield members are formed on the bottom and top surfaces of the circuit board 60 and connected to each other via a through-hole 68c. A ground potential is applied to the shield films 68a and 68b.

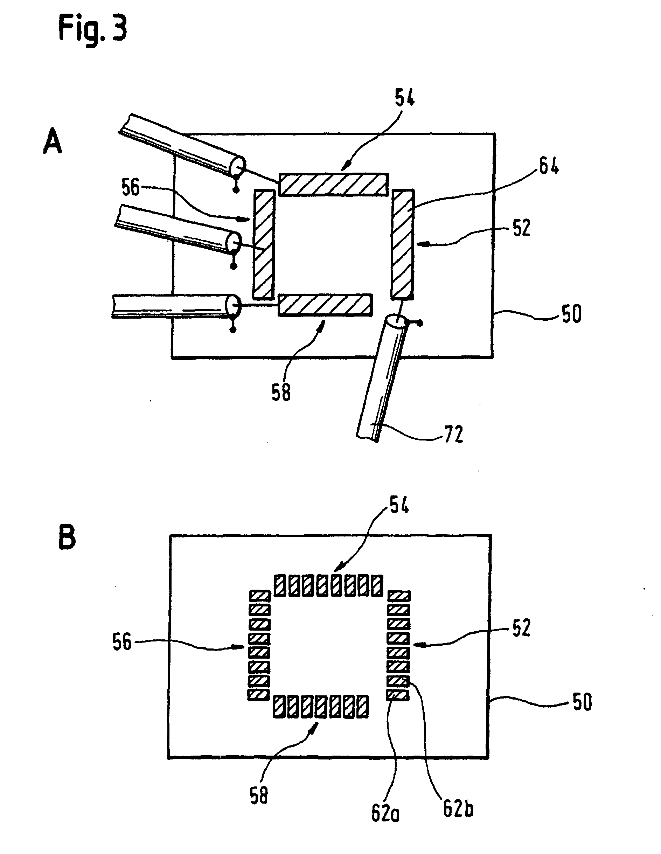

The sensor units 54, 56 and 58 (see Figure 2) constituting the other parts of the sensor module 50 have a similar configuration. Figure 3A shows a plan view of the sensor module 50. Figure 3B is a perspective view of the bottom surface of the sensor module 50 as seen from above.

Figure 7B schematically shows the switch section SW2. The switch section SW2 comprises four switches SW2a, SW2b, SW2c and SW2d. Each switch is turned on and off in response to an instruction from the computer 44 (see Figure 1) to supply a signal detection section 48 with a signal from a desired one of the four sensor units 52, 54, 56 and 58 constituting the sensor module 50 (in this case, only the switch SW2a is turned on), for example, the sensor unit 52.

The signal provided by the desired sensor unit 52 is subjected to a predetermined processing in the detection section 48, as shown in Figure 1, and then delivered to the computer 44. Based on the transmitted signal, the computer 44 determines the continuity of a printed pattern selected by the switch sections SW1 and SW2 (in the above example, the printed pattern 34a). The computer 44, the signal source 46 and the signal detection section 48 constitute a controller 42.

By making the sensor module 50 of the four sensor units 52, 54, 56 and 58 so that a signal can be independently obtained from each sensor unit in this manner, the following advantages can be achieved. As described above, in the pad section 38 (the QFP pattern) of the printed pattern section 34 shown in Figure 2, the pad 38b and the pads 38x, 38y and 38z are connected together by the printed pattern 34x to form a ground line.

Thus, by using the switch section SW1 to select the pad 36b and using the switch section SW2 to select the sensor unit 54 in order to inspect the continuity, it can be determined whether the printed pattern 34x is open-circuited between the pad 38b and the pad 38x.

By designing the sensor module of the plurality of sensor units so that a signal can be independently obtained from each sensor unit, complicated or irregular printed patterns can be inspected accurately.

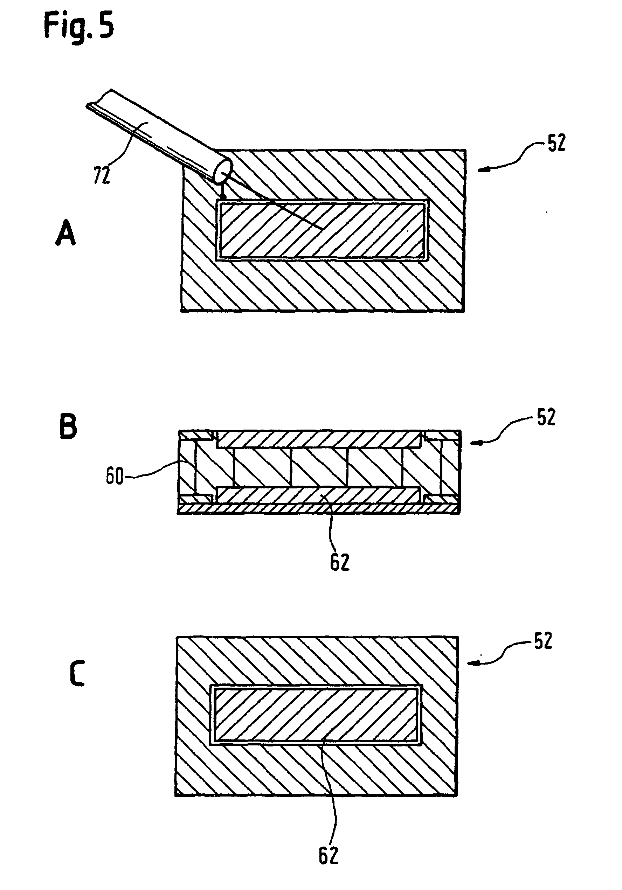

Although the above embodiment provides the plurality of electrode plates 62a, 62b, ... on the bottom surface of the circuit board 60 of the sensor unit 52, as shown in Figures 4B and 4C, a single large electrode plate 62 may be provided on the bottom surface of the circuit board 60 as shown in Figures 5A, 5B and 5C. That is, the single large electrode plate 62 of the sensor unit 52 is coupled to the group of pads 38a, 38b, ... (see Figure 2) corresponding to the sensor unit 52.

This configuration is advantageous because the variation in the electrostatic capacity generated between the electrode plate 62 and the group pads 38a, 38b, ... shown in Figure 2 is relatively small, even if these components are somewhat roughly aligned with one another.

The above embodiment connects the plurality of electrode plates 62a, 62b, ... to the single connection plate 64 to allow all of the plurality of pads 38a, 38b, ... corresponding to the sensor unit 52 shown in Figure 2 to be subjected to a single signal processing, as shown in Figures 4B and 4A. A plurality of connection plates 64a, 64b, ... may be provided on the top surface of the circuit board 60 and connected to the electrode plates 62a, 62b, ... respectively, via the through-holes 66a, 66b, ... to obtain a signal from the connection plates 64a, 64b, ...

This configuration allows the plurality of pads 38a, 38b, ... shown in Figure 2 to be individually subjected to signal processing. This enables more delicate processing to allow the apparatus to inspect more complicated printed patterns. In this case, the pads 38a, 38b, ... individually form a group. That is, each group is composed of only a single pad.

In addition, although the above embodiment integrates the four sensor units 52, 54, 56, and 58 into the sensor module 50, these sensor units may be separately formed. The integration, however, allows the plurality of sensor units to be handled easily compared to when the units are separated. In addition, the integral sensor module 50 can be more efficiently positioned on the circuit board 32.

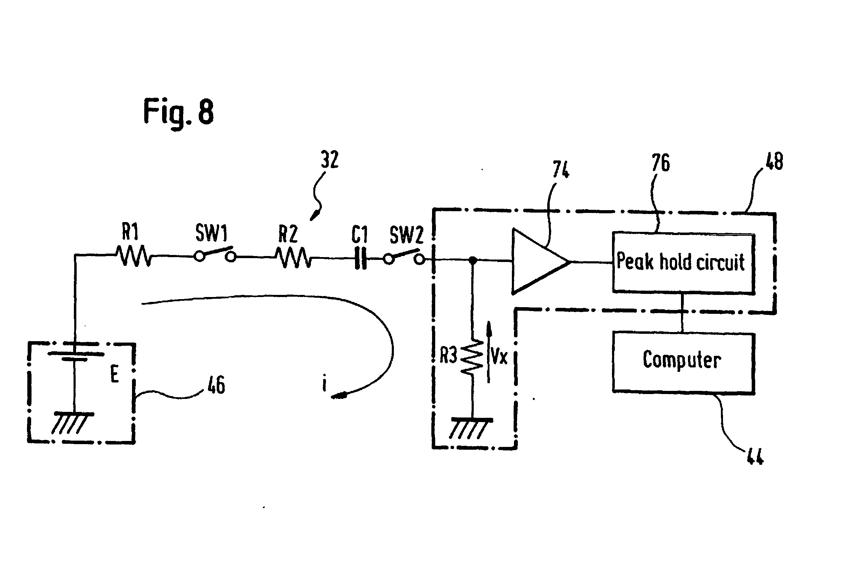

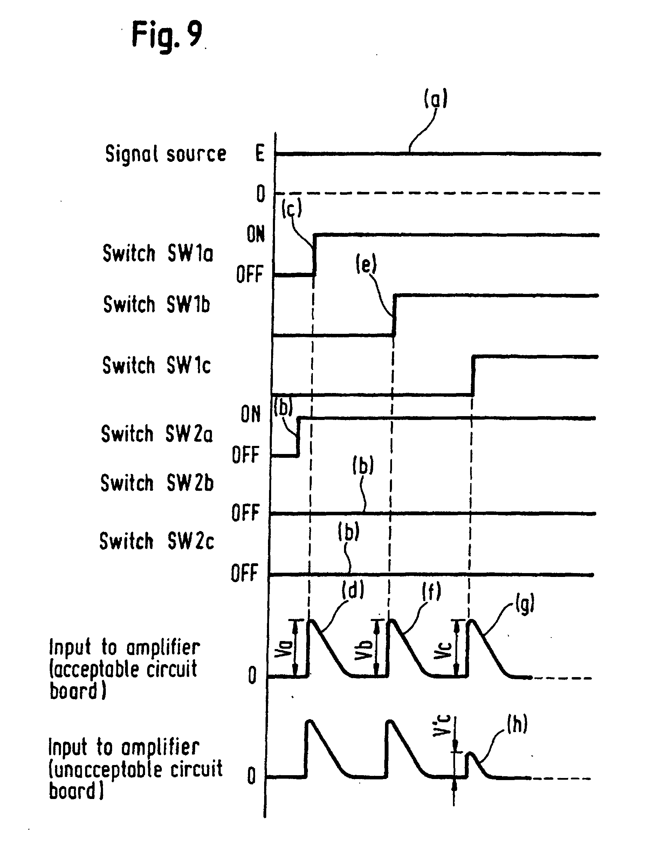

The signal processing executed by the bare-board tester shown in Figure 1 will be described. Figure 8 shows an equivalent circuit used for signal processing. Figure 9 as a timing chart showing the signal processing. The signal processing executed by the bare-board tester will be described with reference to Figures 1, 8 and 9. for the sake of convenience, Figure 9 omits the description of a few switches constituting the switch sections SW1 and SW2.

This embodiment uses a constant-voltage source as the signal source 46 (see (a) in figure 9). Thus, a constant voltage E is applied to the switch SW1 by the signal source 46, as shown in Figure 1. The computer 44 first transmits an instruction to the switch section SW2 to turn on only the switch SW2a while turning off the other switches SW2b, SW2c, and SW2d (see Figures 7B and (b) in Figure 9). Then, only the sensor unit 52 is connected to the signal detection circuit 48, whereas the other sensor units 54, 56, and 58 remain disconnected from the signal detection circuit 48.

The computer 44 then sends an instruction to the switch SW1 to turn on only the switch SW1a (see (c) in Figure 9) while turning off the other switches SW1b, SW1c, ... (see Figure 7A). Then, only the probe 40a is connected to the signal source 46, whereas the probes 40b, 40c, ... remain disconnected from the signal source 46. This causes the printed pattern 34a on the circuit board 32 to be selected and inspected.

In this case, in Figure 8, the resistor R1 represents the internal resistance of the switches SW1a and SW2a, and the resistor R2 represents the resistance of the printed pattern 34a on the circuit board 32. The resistor R3 represents the ground resistance in the signal detection section 48. The capacitance C1 represents a capacitor formed of the electrode plates 62a, 62b, ... of the sensor unit 52, the insulating film 70 (see Figure 4B), and the pads 38a, 38b, ... corresponding to the sensor unit 52. E represents the direct voltage from the signal source 46.

When the switch 1a is turned on (see (c) in Figure 9), the equivalent circuit shown in Figure 8 is closed to allow a current (i) as shown below to flow.

$$i= E/(R1+R2+R3)\cdot\exp(-\alpha t)$$

wherein

$$\alpha=1/\{(R1+R2+R3)\cdot C1\} \qquad (1)$$

Thus, the input voltage Vx into an amplifier 74 is as follows:

$$Vx = R3i=R3/(R1+R2+R3)\cdot E\cdot\exp(-\alpha t)$$

wherein

$$\alpha=1/\{(R1+R2+R3)\cdot C1\} \qquad (2)$$

After the voltage Vx has been amplified by the amplifier 74, a peak hold circuit 76 detects and holds its maximum value (corresponding to the voltage Va in (d) in Figure 9). The peak hold circuit 76 includes a D/A converter (not shown) that digitalizes and transmits the maximum value to the computer 44. Part of the function of the peak hold circuit 76 can be implemented by the computer 44.

Based on the maximum value, the computer 44 determines the continuity of the printed pattern 34a on the circuit board 32. For example, it makes a determination by checking whether the maximum value is between the upper and lower reference limits.

As is apparent from Equation 82), the voltage Vx input to the amplifier 74 causes the maximum value Va (=R3/(R1+R2+R3)·E) to be exhibited at almost the exact same time that the switch SW1a is turned on (see (d) in Figure 9).

Thus, the peak hold circuit 76 can finish detecting the maximum value in a very short time. This enables the continuity of the printed pattern to be determined in a very short time. As a result, the operation is unlikely to be affected by humming noises.

The computer 44 then transmits an instruction to the switch SW1 to turn the switch SW1b on (see (e) in Figure 9). The switch SW1a remains on. Thus, the probes 40a and 40b are connected to the signal source 46. In this case, the condition of the switch section SW2 remains unchanged.

As described above, the voltage Vx input into the amplifier 74 exhibits a maximum value Vb (see (f) in Figure 9) at almost the exact same time that the switch SW1b is turned on (see (e) in Figure 9). The computer 44 determines the continuity of the printed pattern 34b on the circuit board 32 based on the maximum value Vb, as described above.

In this case, although the printed pattern 34a on the substrate 32 is selected together with the printed pattern 34b, the capacitor C1 (see Figure 8) in the equivalent circuit formed of the printed pattern 34a is almost fully charged (the timing with which the switch SW1b is turned on is set to provide this condition). Thus, virtually no current (i) flows through the printed pattern 34a. Consequently, the voltage Vx input to the amplifier 74 is provided only by the current (i) flowing through the printed pattern 34b.

In this embodiment, as described above, the sensor module 50 is composed of the plurality of sensor units 52, 53, ... (see Figure 2), each of which is coupled to the corresponding group of pads via the separate capacitor. Thus, the electrostatic capacity of each capacitor C1 is relatively small. that is, shown in Equation (1) has a relatively large value (that is, the time constant has a correspondingly small value). Thus, the time (t) required until the current (i) almost reaches zero is short, as is apparent from Equation (1). This embodiment can thus determine the continuity of the printed patterns in short cycles.

The computer 44 then switches the switches of the switch sections SW1 and SW2 as required to inspect the continuity of the printed patterns 34c, ... The circuit board 32 is acceptable, as shown in Figure 9, that is, if the printed patterns 34a, 34b, 34c, ... are not open-circuited , the voltage Vx input to the amplifier 74 is as shown in (d), (f), (g), ..., respectively.

On the other hand, if the circuit board 32 is unacceptable, such as if the printed pattern 34c is open-circuited, then the voltage Vx input to the amplifier 74 has a very small maximum value V'c as shown in (h), thereby allowing the unacceptability of this circuit board to be determined easily. This is also indicated in Equation (2), wherein Vx = 0 is established regardless of the time (t) if the resistor R2 representing the resistance of the printed pattern has an infinite value (a fully open circuit).

This embodiment thus allows the continuity of the printed pattern to be inspected promptly and accurately.

Although this embodiment turns on the switch SW1b while keeping the switch 1a on (see (c) and (e) in Figure 9), the switch SW1a may be turned off immediately after the peak hold circuit 76 has finished detecting the maximum value for the printed pattern 34a (the maximum value corresponding to the voltage Va), followed by the turning-on of the switch SW1b. This configuration eliminates the need to wait for the current (i) flowing through the printed pattern 34a to reach almost zero before starting to inspect the next printed pattern 34b. Thus, the continuity of the printed patterns can be inspected in shorter cycles. This configuration also prevents the length of the inspection cycle from being significantly increased even if the time constant (the inverse of $\alpha$ in Equations (1) and (2)) is large.

In addition, although the above embodiment uses the constant-voltage source as the signal source 46 (see (a) in Figure 9) and turns each switch of the switch section SW1 on and off (see (c) and (e) in Figure 9) to obtain a voltage with a step-shaped waveform and sharp rising edges, a circuit that sequentially generates signals with rapid changes may be used as the signal source 46.

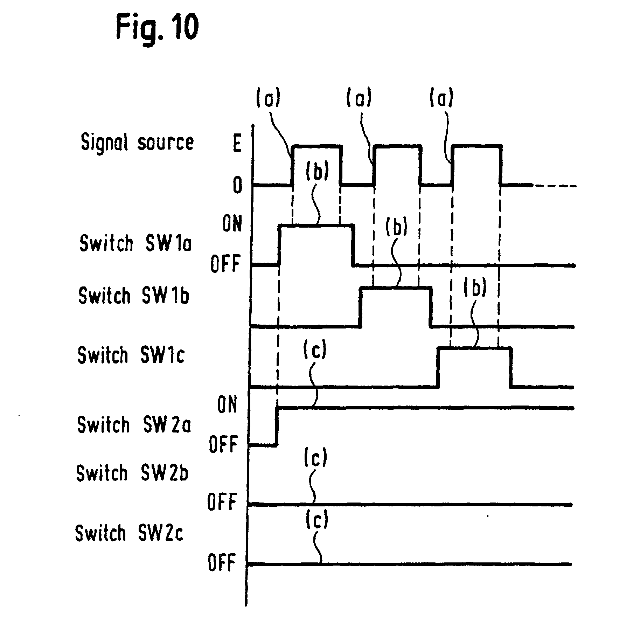

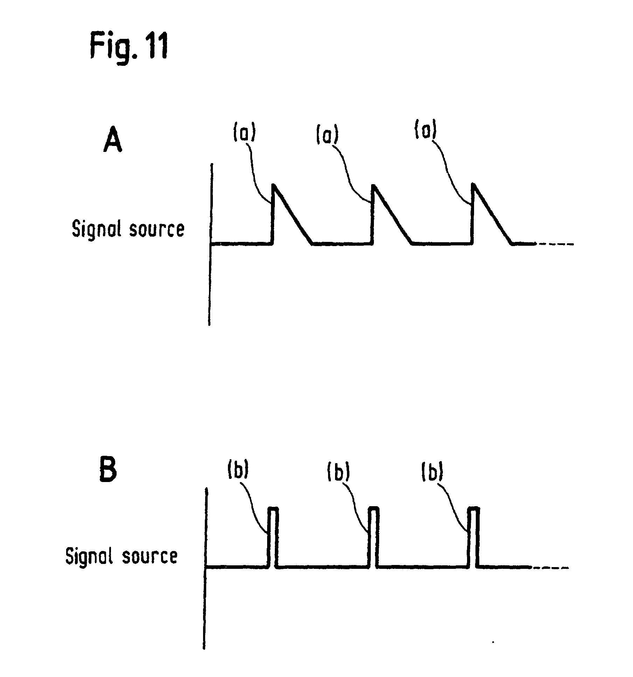

Figure 10 shows a timing chart of signal-processing executed when the signal source 46 described above is used. This example employs a rectangular-wave generation circuit as the signal source 46. By activating the switch SW1 or SW2 almost in synchronism with the phase of the rising edge of each rectangular signal (see (a) in Figure 10), the computer 44 distributes among the printed patterns 34a, 34b, ... each rectangular signal sequentially generated by the signal source 46 (Figure 11). The condition of the voltage Vx input to the amplifier 74 and the processing executed after it has been input to the amplifier 74 are similar to those in the example shown in Figure 9.

Although in the example shown in Figure 10, the signal source 46 generates rectangular waves, the source 46 may be configured to generate triangular waves as shown in Figure 11A. In this figure, each triangular wave has sharp rising edges (a). The signal source 46 may be configured to generate a pulse train as shown in Figure 11B. In this figure, each pulse signal has sharp rising edges (b), as in Figure 11A.

Signals having sharp rising edges are not limited to those described above. It includes not only those taking no time to rise but also those taking a little time to do. It also includes those having sharp falling edges.

Although the above embodiment determines the continuity of the wiring based on the maximum voltage generated at the second terminal after the signal has changed rapidly, this invention is not limited to this aspect. This invention may be configured to determine the continuity of the wiring based on a quantity relating to the voltage generated between the first and second terminals when a signal with rapid changes is applied, such as the average of the voltage within a specified period of time, the voltage value obtained after a specified period of time, the steady-state deviation voltage, or the maximum, average, or integral value of the current flowing between the first and second terminals, all values obtained after the signal has changed rapidly. The continuity of the wiring, however, can be determined in a shorter time by determining it based on the maximum voltage, as in the above embodiment.

In addition, although the above embodiment has been described in conjunction with signals with rapid changes, this invention is not limited to this aspect.

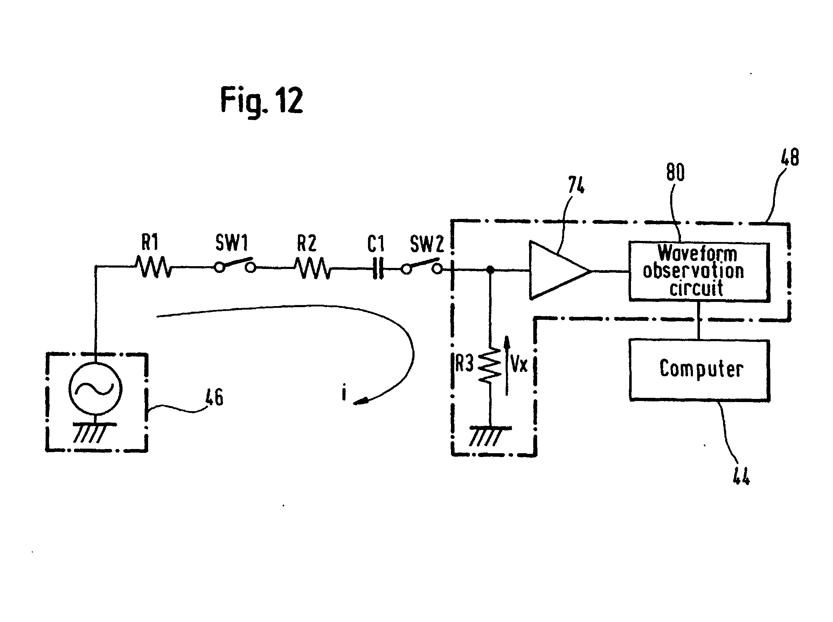

If an alternating signal is used as the predetermined signal, a sine-wave generator, for example, may be used as the signal source 46, as shown in Figure 12. For example, a sine wave with a frequency of approximately 10 MHz is generated by the signal source 46. The signal detection section 48 may be composed of a waveform observation circuit 80 instead of the peak hold circuit 76 in Figure 8. the wave observation circuit 80 is a circuit for processing an input signal and evaluating its level and waveform such as that from a wave detector or an oscilloscope.

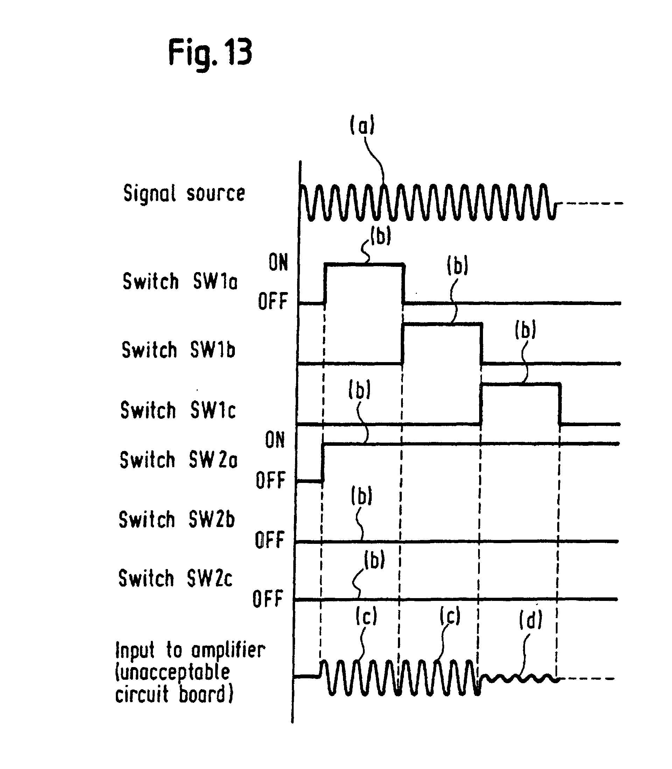

In this case, the computer 44 turns each of the switches SW1 and SW2 on and off as required (see (b) in Figure 13) to distribute among the printed patterns 34a, 34b, 34c, ... a sine wave generated by the signal source 46 (see (a) in Figure 13), while determining the continuity of each printed pattern based on the data obtained via the signal detection section 48, as shown in Figure 13.

If no printed pattern is open-circuited, the voltage Vx input to the amplifier 74 is as shown in (c). On the other hand, if any printed pattern is open-circuited, the voltage Vx is as shown in (d). That is, the open circuit of the printed pattern can be determined easily because it reduces the input level of the signal to a very small value. In the example in Figure 13, the printed pattern 34c is open-circuited though the printed patterns 34a and 34b are not, so this circuit board 32 is determined to be unacceptable.

If such an alternating signal is used, inspections cannot be conducted as promptly as in the embodiment using a signal with rapid changes. The use of such an alternating signal, however, allows the apparatus to be composed of a circuit such as a sine-wave generator or a wave detector that is relatively often used for a non-contact inspection apparatus. The use of such a signal is thus expected to reduce the design cost of the apparatus and the time required for delivery, as well as to reduce the manufacturing cost of the apparatus by allowing existing parts to be used for it.

Part or all of the functions of the computer 44 shown in Figure 1 can also be implemented using hardware logic. In addition, part or all of the functions of the signal source 46 or the signal detection section 48 can also be implemented using the computer.

Although the above embodiment disposes shield members around the electrode section, the shield members may be eliminated. The use of the shield members, however, can reduce noise.

In addition , although the above embodiment provides on the second terminal insulating film covering the electrode section, the insulating film may be eliminated. By providing insulating film on the second terminal, however, inspections can be conducted promptly, as the need to prepare separate insulating films prior to inspection is eliminated.

In addition, although the above embodiment provides the electrode section on one side of the circuit board constituting the sensor module, while providing on the other side the connection-conducting section electrically connected to the electrode section, the connection-conducting section on the other side may be eliminated. By providing the connection-conducting section on the other side, however, the structure of the sensor module can be simplified, as a signal can be transmitted easily via this section.

In addition, although in the above embodiment the sensor module is composed of the circuit board that is manufactured by a process similar to that used for the inspected circuit board, it may be made of a circuit board that is manufactured by a process dissimilar to that used for the inspected circuit board, or may be configured without a circuit board. By manufacturing the sensor module by a process similar to that used for the inspected circuit board, however, if the density or complexity of the wiring on the inspected circuit board has been increased, the density or complexity of the sensor module can be conveniently increased correspondingly.

In addition, although in the above embodiment the second terminal is capacitively coupled to the other end of the wiring, it may be inductively coupled to this other end. The capacitive coupling, however, enables reliable inspections to be conducted using a simple configuration.

In addition, although the above embodiment connects the first terminal to one end of the wiring, the first terminal may be capacitively connected to one end of the wiring.

In addition, although the above embodiment provides a plurality of first terminals and uses the first switch means to select a desired first terminal in order to select one of the one ends of the wiring on the inspected circuit board, only one first terminal may be provided and the inspected circuit board may be moved relative to this first terminal to select one of the ends of the wiring. The former configuration, however, eliminates the need to move the inspected circuit board relative to the first terminal, thereby enabling inspections to be conducted very accurately, reducing the manufacturing cost of the apparatus, and allowing inspections to be automated easily.

In addition, although the above embodiment has been described with the inspected circuit board having wiring with a plurality of other ends connected together , this invention is not limited to the inspection of such a circuit board.

In addition, although the above embodiment has been described with the bare-board tester, this invention is not limited to such a tester. This invention is applicable to general circuit board inspection apparatuses and methods, such as those in which a circuit board on which circuit elements such as a CPU are mounted or a package on which circuit elements are mounted is inspected.

## Claims

1. A circuit board inspection apparatus for inspecting wiring (34) formed on a circuit board (32), and having a plurality of first ends (36) and a plurality of second ends (38), the apparatus comprising a first terminal section (40) for being connected or coupled to the first ends (36) and a plurality of sensor units (52, 54, 56, and 58) for being capacitively coupled to the second ends (38) in order to detect the continuity of said wiring based on the signal transmitted through the capacitive coupling when a predetermined signal is delivered to the first end of the wiring through the first terminal section (40), wherein the apparatus is adapted to inspect a circuit board having a pattern or line (34b) which is branched to a plurality of ends (38b, 38x, 38y and 38z), and wherein said plurality of sensor units (52, 54, 56, and 58) are arranged such that each sensor unit (e. g., 52) is coupled with the second ends (e.g., 38a, 38b, 38c ...) with the branched ends (38b, 38x, 38y and 38z) being respectively coupled with different sensor units (52, 54, 56 or 58).

2. A circuit board inspection apparatus according to claim 1, wherein each sensor unit (52-58) includes an electrode section (62; 62a, 62b) for being arranged opposite to said second ends (38) of said wiring and for being capacitively coupled to the second ends (38).

3. A circuit board inspection apparatus according to claim 2, wherein pads (38a, 38b, 38c and 38x) are formed at the second ends (38) and the pads are capacitively coupled with the electrode section (62; 62a, 62b).

4. A circuit board inspection apparatus according to any of claim 1 through 3, wherein pads (36; 36a, 36b, 36c ...) are formed at the first ends (36) and the first terminal section includes a plurality of probes (40; 40a, 40b ...) for being in contact with the pads (36; 36a, 36b, 36c ...) at the first ends.

5. A circuit board inspection apparatus according to claim 2, wherein said electrode section (62) is continuously provided opposite to the pads (38a, 38b, 38c, 38x) at the second ends (38) of said wiring.

6. A circuit board inspection apparatus according to claim 2, wherein said electrode section (62a, 62b) is discontinuously provided in such a way that it comprises a plurality of electrode plates (62a, 62b) that are arranged to be opposed to each of the pads (38a, 38b, 38c, 38x) at the second ends (38) of said wiring.

7. A circuit board inspection apparatus according to any of claims 2 to 6, wherein each sensor unit (52-58) includes a shield member (68a) around said electrode section (62; 62a, 62b).

8. A circuit board inspection apparatus according to any of claims 2 to 7, wherein each sensor unit (52-58) includes an insulating film (70) covering said electrode section (62; 62a, 62b).

9. A circuit board inspection apparatus according to any of claims 1 to 8, wherein said plurality of sensor units (52-58) are integrated to form a sensor module (50).

10. A circuit board inspection apparatus according to claim 9, wherein said sensor module (50) is composed of a circuit board that can be manufactured through a process similar to that of an inspected circuit board.

11. A circuit board inspection apparatus according to any of claims 1 to 10, comprising:

    a plurality of first terminals (40a, 40b) forming said first terminal section (40), to be connected or coupled to said first ends (36) of said wiring;

    a first switch means (SW1) for selecting a desired one of the plurality of first terminals (40a, 40b); and

a second switch means (SW2) for selecting a desired one of said plurality of sensor units (52-58), wherein the first and the second switch means (SW1, SW2) are used to detect the continuity of the wire identified by a selected first terminal (40a, 40b) and a selected sensor unit (52-58).

**12.** A circuit board inspection apparatus according to any of claims 1 to 11, wherein said predetermined signal is an alternating signal.

**13.** A circuit board inspection apparatus according to any of claims 1 to 12, wherein said predetermined signal changes its electric parameter rapidly to be transmitted through the capacitive coupling.

**14.** A circuit board inspection apparatus according to any one of claims 1 to 13, wherein said second ends (38) are composed of a plurality of groups of ends with the branched ends belonging to different groups, and said sensor units are respectively coupled with the group of ends.

**15.** A circuit board inspection apparatus according to any of claims 1 through 14, wherein said circuit board to be inspected is a bare circuit board (32).

**16.** A circuit board inspection method for inspection wiring formed on a circuit board (32) and having a plurality of first ends (36) and a plurality of second ends (38) including ends (38b, 38x, 38y and 38z) branched from one (36b) of the first ends, the method comprising the following steps:

- connecting or coupling a first terminal section (40) to the first ends (36) of said wiring;

- capacitively coupling a sensor unit to the second ends (38) of said wiring in the manner that different sensor units are coupled with different ends of said branched ends (38b, 38x, 38y and 38z) along with other second ends;

- delivering a predetermined signal to the first ends (36) through the first terminal section (40), the predetermined signal being of the nature changing its electric parameter rapidly to be transmitted through the capacitive coupling; and

- detecting the continuity of said wiring based on the predetermined signal transmitted through the capacitive coupling.

**17.** A circuit board inspection method for inspection wiring formed on a circuit board according to claim 16, further comprising the steps of grouping the second ends into a plurality of groups each of which includes different end of said branched ends (38b, 38x, 38y and 38z) and coupling the sensor units to respective groups of second ends.

**Patentansprüche**

**1.** Schaltplattenprüfvorrichtung zum Prüfen einer Verdrahtung (34), die auf einer Schaltplatte (32) gebildet ist, und eine Vielzahl von ersten Enden (36) und eine Vielzahl von zweiten Enden (38) hat, wobei die Vorrichtung einen ersten Anschlussabschnitt (40) umfasst, welcher vorgesehen ist, mit den ersten Enden (36) verbunden oder gekoppelt zu werden, und eine Vielzahl von Sensoreinheiten (52, 54, 56 und 58), welche vorgesehen sind, um mit den zweiten Enden (38) kapazitiv gekoppelt zu werden, um die Kontinuität der Verdrahtung auf der Grundlage des durch die kapazitive Kopplung übertragenen Signals zu erfassen, wenn ein vorbestimmtes Signal dem ersten Ende der Verdrahtung durch den ersten Anschlussabschnitt (40) geliefert wird, wobei die Vorrichtung ausgebildet ist, eine Schaltplatte zu prüfen, welche ein Muster oder eine Leitung (34b) hat, die in eine Vielzahl von Enden (38b, 38x, 38y und 38z) verzweigt ist, und wobei die Vielzahl von Sensoreinheiten (52, 54, 56 und 58) so angeordnet ist, dass jede Sensoreinheit (z.B. 52) mit den zweiten Enden (z.B. 38a, 38b, 38c ...) gekoppelt ist, und die verzweigten Enden (38b, 38x, 38y und 38z) jeweils mit unterschiedlichen Sensoreinheiten (52, 54, 56 oder 58) gekoppelt sind.

**2.** Schaltplattenprüfvorrichtung nach Anspruch 1, wobei jede Sensoreinheit (52-58) einen Elektrodenabschnitt (62; 62a, 62b) enthält, welcher vorgesehen ist, um gegenüber den zweiten Enden (38) der Verdrahtung angeordnet zu werden, und um mit den zweiten Enden (38) kapazitiv gekoppelt zu werden.

**3.** Schaltplattenprüfvorrichtung nach Anspruch 2, wobei Felder (38a, 38b, 38c und 38x) an den zweiten Enden (38) gebildet sind, und die Felder mit dem Elektrodenabschnitt (62; 62a, 62b) kapazitiv gekoppelt sind.

**4.** Schaltplattenprüfvorrichtung nach einem der Ansprüche 1 bis 3, wobei Felder (36; 36a, 36b, 36c ...) an den ersten Enden (36) gebildet sind, und der erste Anschlussabschnitt eine Vielzahl von Sonden (40; 40a, 40b ...) enthält, welche vorgesehen sind, um mit den Feldern (36; 36a, 36b, 36c ...) an den ersten Enden in Kontakt zu sein.

**5.** Schaltplattenprüfvorrichtung nach Anspruch 2, wobei der Elektrodenabschnitt (62) gegenüber den Feldern (38a, 38b, 38c, 38x) an den zweiten Enden (38) der Verdrahtung kontinuierlich vorgesehen ist.

6. Schaltplattenprüfvorrichtung nach Anspruch 2, wobei der Elektrodenabschnitt (62a, 62b) auf solche Art diskontinuierlich vorgesehen ist, dass er eine Vielzahl von Elektrodenplatten (62a, 62b) umfasst, welche angeordnet sind, um jedem der Felder (38a, 38b, 38c, 38x) an den zweiten Enden (38) der Verdrahtung gegenüber zu stehen.

7. Schaltplattenprüfvorrichtung nach einem der Ansprüche 2 bis 6, wobei jede Sensoreinheit (52-58) ein Abschirmglied (68a) um den Elektrodenabschnitt (62; 62a, 62b) enthält.

8. Schaltplattenprüfvorrichtung nach einem der Ansprüche 2 bis 7, wobei jede Sensoreinheit (52-58) eine Isolierschicht (70) enthält, welche den Elektrodenabschnitt (62; 62a, 62b) bedeckt.

9. Schaltplattenprüfvorrichtung nach einem der Ansprüche 1 bis 8, wobei die Vielzahl von Sensoreinheiten (52-58) integriert sind, um ein Sensormodul (50) zu bilden.

10. Schaltplattenprüfvorrichtung nach Anspruch 9, wobei das Sensormodul (50) aus einer Schaltplatte besteht, welche durch einen Prozess hergestellt werden kann, der jenem einer geprüften Schaltplatte ähnlich ist.

11. Schaltplattenprüfvorrichtung nach einem der Ansprüche 1 bis 10, umfassend:

    - eine Vielzahl von ersten Anschlüssen (40a, 40b), welche den ersten Anschlussabschnitt (40) bilden, um mit ersten Enden (36) der Verdrahtung verbunden oder gekoppelt zu werden;

    - ein erstes Schaltmittel (SW1) zur Auswahl eines gewünschten Anschlusses der Vielzahl von ersten Anschlüssen (40a, 40b); und

    - ein zweites Schaltmittel (SW2) zur Auswahl einer gewünschten Sensoreinheit der Vielzahl von Sensoreinheiten (52-58), wobei das erste und zweite Schaltmittel (SW1, SW2) verwendet wurden, um die Kontinuität des Drahtes zu prüfen, der durch einen gewählten ersten Anschluss (40a, 40b) und eine gewählte Sensoreinheit (52-58) identifiziert wird.

12. Schaltplattenprüfvorrichtung nach einem der Ansprüche 1 bis 11, wobei das vorbestimmte Signal ein wechselndes Signal ist.

13. Schaltplattenprüfvorrichtung nach einem der Ansprüche 1 bis 12, wobei das vorbestimmte Signal seinen elektrischen Parameter rasch verändert, um durch die kapazitive Kopplung übertragen zu werden.

14. Schaltplattenprüfvorrichtung nach einem der Ansprüche 1 bis 13, wobei die zweiten Enden (38) aus einer Vielzahl von Gruppen von Enden bestehen, wobei die verzweigten Enden zu unterschiedlichen Gruppen gehören, und die Sensoreinheiten jeweils mit der Gruppe von Enden gekoppelt sind.

15. Schaltplattenprüfvorrichtung nach einem der Ansprüche 1 bis 14, wobei die zu prüfende Schaltplatte eine nackte Schaltplatte (32) ist.

16. Schaltplattenprüfverfahren zum Prüfen einer Verdrahtung, die auf einer Schaltplatte (32) gebildet ist und eine Vielzahl von ersten Enden (36) und eine Vielzahl von zweiten Enden (38) hat, einschließlich Enden (38b, 38x, 38y und 38z), die sich von einem (36b) der ersten Enden verzweigen, wobei das Verfahren die folgenden Schritte umfasst:

    - Verbinden oder Koppeln eines ersten Anschlussabschnitts (40) mit den ersten Enden (36) der Verdrahtung;

    - kapazitives Koppeln einer Sensoreinheit mit den zweiten Enden (38) der Verdrahtung auf solche Weise, dass unterschiedliche Sensoreinheiten mit unterschiedlichen Enden der verzweigten Enden (38b, 38x, 38y und 38z) gekoppelt sind, zusammen mit anderen zweiten Enden;

    - Liefern eines vorbestimmten Signals an die ersten Enden (36) durch den ersten Anschlussabschnitt (40), wobei das vorbestimmte Signal dergestalt ist, dass es seinen elektrischen Parameter rasch ändert, um durch die kapazitive Kopplung übertragen zu werden; und

    - Erfassen der Kontinuität der Verdrahtung auf der Grundlage des durch die kapazitive Kopplung übertragenen vorbestimmten Signals.

17. Schaltplattenprüfverfahren zum Prüfen einer auf einer Schaltplatte gebildeten Verdrahtung nach Anspruch 16, ferner umfassend die Schritte des Gruppierens der zweiten Enden in eine Vielzahl von Gruppen, wovon jede unterschiedliche Enden der verzweigten Enden (38b, 38x, 38y und 38z) enthält, und Koppeln der Sensoreinheiten mit jeweiligen Gruppen von zweiten Enden.

**Revendications**

1. Dispositif de contrôle de carte de circuit destiné à inspecter le câblage (34) formé sur une carte de circuit (32) et comportant une pluralité de premières extrémités (36) et une pluralité de secondes extrémités (38), l'appareil comprenant une première section de terminal (40) destinée à être connectée ou couplée aux premières extrémités (36) et une pluralité d'unités de capteurs (52, 54, 56 et 58) destinées à être couplées en régime capacitif aux secondes extrémités (38) pour détecter la continuité dudit câblage en fonction du signal transmis par le couplage capacitif lorsqu'un signal prédéterminé est délivré à la première extrémité dudit câblage par l'intermédiaire de la première section de terminal (40), dans lequel l'appareil est apte à contrôler une carte de circuit comportant une impression ou une ligne (34b) qui est raccordée à une pluralité d'extrémités (38b, 38x, 38y et 38z), et dans lequel ladite pluralité d'unités de capteurs (52, 54, 56 et 58) est disposée de telle sorte que chaque unité de capteur (par exemple 52) est couplée aux secondes extrémités (par exemple 38a, 38b, 38c ...), les extrémités raccordées (38b, 38x, 38y et 38z) étant respectivement couplées aux différentes unités de capteurs (52, 54, 56 ou 58).

2. Dispositif de contrôle de carte de circuit selon la revendication 1, dans lequel chaque unité de capteur (52-58) comprend une section d'électrode (62 ; 62a, 62b) destinée à être agencée en opposition aux dites secondes extrémités (38) dudit câblage et destinée à être couplée en régime capacitif aux secondes extrémités (38).

3. Dispositif de contrôle de carte de circuit selon la revendication 2, dans lequel des pastilles (38a, 38b, 38c et 38x) sont formées sur les secondes extrémités (38) et les pastilles sont couplées en régime capacitif à la section d'électrode (62 ; 62a, 62b).

4. Dispositif de contrôle de carte de circuit selon l'une quelconque des revendications 1 à 3, dans lequel les pastilles (36 ; 36a, 36b, 36c ...) sont formées sur les premières extrémités (36) et la première section de terminal comprend une pluralité de sondes (40 ; 40a, 40b ...) pour être en contact avec les pastilles (36 ; 36a, 36b, 36c ...) sur les premières extrémités.

5. Dispositif de contrôle de carte de circuit selon la revendication 2, dans lequel ladite section d'électrode (62) est prévue en continu de façon opposée aux pastilles (38a, 38b, 38c, 38x) sur les secondes extrémités (38) dudit câblage.

6. Dispositif de contrôle de carte de circuit selon la revendication 2, dans lequel ladite section d'électrode (62a, 62b) est prévue de façon discontinue de telle sorte qu'elle comprend une pluralité de plaques d'électrodes (62a, 62b) qui sont disposées de façon à être opposées à chacune des pastilles (38a, 38b, 38c, 38x) sur les secondes extrémités (38) dudit câblage.

7. Dispositif de contrôle de carte de circuit selon l'une quelconque des revendications 2 à 6, dans lequel chaque unité de capteur (52-58) comprend un élément de protection (68a) autour de ladite section d'électrode (62 ; 62a, 62b).

8. Dispositif de contrôle de carte de circuit selon l'une quelconque des revendications 2 à 7, dans lequel chaque unité de capteur (52-58) comprend un film isolant (70) recouvrant ladite section d'électrode (62 ; 62a, 62b).

9. Dispositif de contrôle de carte de circuit selon l'une quelconque des revendications 1 à 8, dans lequel ladite pluralité d'unités de capteurs (52-58) est intégrée pour former un module de capteur (50).

10. Appareil de contrôle de carte de circuit selon la revendication 9, dans lequel ledit module de capteur (50) est composé d'une carte de circuit qui peut être fabriquée par un procédé similaire à celui d'une carte de circuit contrôlée.

11. Appareil de contrôle de carte de circuit selon l'une quelconque des revendications 1 à 10, comprenant :

    une pluralité de premiers terminaux (40a, 40b) formant ladite première section de terminal (40), à connecter ou à coupler auxdites premières extrémités (36) dudit câblage ;
    des premiers moyens de commutation (SW1) pour sélectionner un terminal souhaité de la pluralité des premiers terminaux (40a, 40b) ; et des seconds moyens de commutation (SW2) pour sélectionner une unité souhaitée de ladite pluralité d'unités de capteurs (52-58), dans lequel les premiers et seconds moyens de commutation (SW1, SW2) sont utilisés pour détecter la continuité du fil identifié par un premier terminal sélectionné (40a, 40b) et une unité de capteur sélectionnée (52-58).

12. Dispositif de contrôle de carte de circuit selon l'une quelconque des revendications 1 à 11, dans lequel ledit signal prédéterminé est un signal alternatif.

13. Dispositif de contrôle de carte de circuit selon l'une quelconque des revendications 1 à 12, dans lequel ledit signal prédéterminé modifie son paramètre électrique rapidement pour être transmis par le couplage capacitif.

**14.** Dispositif de contrôle de carte de circuit selon l'une quelconque des revendications 1 à 13, dans lequel lesdites secondes extrémités (38) sont constituées d'une pluralité de groupes d'extrémités avec les extrémités raccordées faisant partie de différents groupes et lesdites unités de capteurs sont respectivement couplées au groupe d'extrémités.

**15.** Dispositif de contrôle de carte de circuit selon l'une quelconque des revendications 1 à 14, dans lequel ladite carte de circuit à inspecter est une carte de circuit nue (32).

**16.** Procédé de contrôle de carte de circuit pour inspecter le câblage formé sur une carte de circuit (32) et ayant une pluralité de premières extrémités (36) et une pluralité de secondes extrémités (38) comprenant des extrémités (38b, 38x, 38y et 38z) raccordées à partir de l'une (36b) des premières extrémités, le procédé comprenant les étapes suivantes :

- connecter ou coupler une première section de terminal (40) aux premières extrémités (36) dudit câblage ;
- coupler de manière capacitive une unité de capteur aux secondes extrémités (38) dudit câblage, de sorte que différentes unités de capteurs sont couplées à différentes extrémités desdites extrémités raccordées (38b, 38x, 38y et 38z) conjointement à d'autres secondes extrémités ;
- délivrer un signal prédéterminé aux premières extrémités (36) par la première section de terminal (40), le signal prédéterminé étant de nature à modifier son paramètre électrique rapidement pour être transmis par le couplage capacitif ; et
- détecter la continuité dudit câblage basé sur le signal prédéterminé transmis par le couplage capacitif.

**17.** Procédé de contrôle de carte de circuit pour inspecter le câblage formé sur une carte de circuit selon la revendication 16, comprenant en outre les étapes consistant à regrouper les secondes extrémités en une pluralité de groupes dont chacun comprend différentes extrémités desdites extrémités raccordées (38b, 38x, 38y et 38z) et à coupler des unités de capteurs aux groupes respectifs des secondes extrémités.

EP 0 862 062 B1

# Fig. 1

Figure with labels: 42, 44, Controller, Computer, 48, 46, Signal detection section, Signal source, SW1, Switch section, SW2, Switch section, 40, 40a, 40b, 34, 36, 36a, 36b, 54, 34a, 34b, 56, 52, 50, 58, 32, 72

Fig. 2

# Fig. 3

A

B

# Fig. 4

# Fig. 5

## Fig. 6

A

64a

64b

52

B

64a    64b

60

66a

62a    62b    66b

52

C

52

62a    62b

# Fig. 7

**A**

To signal source 46

SW1b

SW1a

SW1c

SW1

To probe section 40

**B**

To signal detection section 48

SW2d

SW2b

SW2c

SW2a

SW2

To sensor module 50

# Fig. 8

EP 0 862 062 B1

# Fig. 9

Signal source

Switch SW1a

Switch SW1b

Switch SW1c

Switch SW2a

Switch SW2b

Switch SW2c

Input to amplifier (acceptable circuit board)

Input to amplifier (unacceptable circuit board)

# Fig. 10

# Fig. 11

**A**

(a)     (a)     (a)

Signal source

**B**

(b)     (b)     (b)

Signal source

## Fig. 12

EP 0 862 062 B1

# Fig. 13

Fig. 14

Fig. 15    A                    B

EP 0 862 062 B1